# EUROPEAN PATENT APPLICATION

(11) **EP 4 761 470 A1**
(43) Date of publication of application: **17.06.2026**
(21) Application number: 24219320.9
(22) Date of filing: 12.12.2024
(51) Int. Cl.: H05B 47/175, H05B 47/115, G05B 19/04, G06V 10/25, G06F 30/13

(54) **USER DEVICE AND COMPUTER PROGRAM FOR COMMISSIONING A SENSOR DEVICE, SENSOR DEVICE AND COMPUTER PROGRAM FOR A SENSOR DEVICE**

(71) Applicant: Tridonic GmbH & Co. KG, 6851 Dornbirn (AT)
(72) Inventor: Schmölzer, Andreas, 6851 Dornbirn (AT); Carracedo Cordovilla, Luis Javier, 6851 Dornbirn (AT)
(74) Representative: Beder, Jens

(57) **Abstract**

The present invention provides a user device (1) for commissioning a sensor device (2) in an area. The user device (1) is configured to generate (11) a three-dimensional model of the area using three-dimensional spatial data of the area, display (12) the generated three-dimensional model of the area to a user (3), receive (13) from the user (3) information on a desired installation location and orientation of the sensor device in the area and on one or more desired spatial conditions in the area to be considered by the sensor device for evaluating detection results of the area by the sensor device (1), generate (14) a second three-dimensional model of the area using the three-dimensional model of the area and the received information, the second three-dimensional model of the area comprising the received information, and provide (15) the generated second three-dimensional model of the area to the sensor device (2).

## Description

The present invention relates to a user device for commissioning a sensor device, a computer program for commissioning a sensor device in an area, a sensor device, a computer program for a sensor device, a system comprising the user device and the sensor device, and a method for commissioning, by a user device, a sensor device.

A sensor device is used in an area, such as an indoor or outdoor area, for measuring or detecting physical parameter(s), such as temperature, light intensity, air quality, humidity etc., characteristics of the area, such as location of walls, doors, windows etc. of a room, and/or objection(s) being present in the area, such as person(s), furniture etc. In order to set up the sensor device installed in the area with regard to a measurement/detection target in the area, the sensor device is commissioned in the area.

The sensor device may be configured to take an image of the area in which it is installed. Thus, for commissioning the sensor device in the area, the sensor device may take an image of the area and transmit the image to a user device for commissioning the sensor device. The user device may display the image to the user in order for the user to indicate e.g. one or more subareas of the area with regard to which the sensor device is to evaluate the image data of the image of the area in order to provide desired information on the area with regard to such one or more subareas. For example, the sensor device may be used to evaluate the number of persons being present in a subarea of the area. The area may be for example a room, wherein the subarea may be defined matching to a region for which light emission control is to be performed. Thus, it may be desired to determine the number of person inside the aforementioned region in order to be able to control the light emission depending on the number of person being present in the region.

When the image data of the image of the area are transmitted from the sensor device to the user device users of the user device may have concerns with regard to data security and violation of privacy of persons being present in the area and, thus, being identifiable from the image data. This may be actually unfound as conventionally the sensor device and/or the user device anonymize the image data by blurring the parts of the image data relating to sensitive image data, such as image data comprising information on the appearance of persons that allows persons to be identified. However, in practice it can be difficult to convince users that such blurring of image data is sufficient for protecting the privacy. Moreover, in case the blurring is done at the user device, there can be a violation of privacy when the transmitted image data are being hacked during the transmission. In addition, the transmission of the image data for the commissioning of the sensor device by the user device may result in a unwanted data traffic.

Therefore, it is an object of the present invention to provide a commissioning of a sensor device in an area that is improved with regard to protecting privacy of persons and/or reducing an amount of data being transmitted from the sensor device to a user device used for commissioning the sensor device. In particular, it is an object of the present invention to provide a commissioning of a sensor device configured to take an image of an area that is improved with regard to protecting privacy of persons and/or reducing an amount of data being transmitted from the sensor device to a user device used for commissioning the sensor device.

These and other objects, which become apparent upon reading the following description, are solved by the subject-matter of the independent claim. The dependent claims refer to preferred embodiments of the invention.

According to a first aspect of the invention, a user device for commissioning a sensor device in an area is provided. The user device is configured to generate a three-dimensional model of the area using three-dimensional spatial data of the area. The user device is configured to display the generated three-dimensional model of the area to a user. The user device is configured to receive from the user information on a desired installation location and orientation of the sensor device in the area and on one or more desired spatial conditions in the area to be considered by the sensor device for evaluating detection results of the area by the sensor device. The user device is configured to generate a second three-dimensional model of the area using the three-dimensional model of the area and the received information, the second three-dimensional model of the area comprising the information on the desired installation location and orientation of the sensor device in the area and the one or more desired spatial conditions in the area. The user device is configured to provide the generated second three-dimensional model of the area to the sensor device.

In other words, with regard to commissioning a sensor device in an area, the first aspect proposes using three-dimensional spatial data of the area for generating a three-dimensional model of the area in order for a user to indicate based on the generated three-dimensional model a desired installation location and orientation of the sensor device in the area and one or more spatial conditions in the area to be considered by the sensor device when performing detection of the area and evaluation of the detection results. Since, the user device generates a three-dimensional model of the area and, thus, does not display image data of the area (e.g. provided by the sensor device),the privacy of persons being present in the area is protected. Thus, this allows meeting regulations with regard to data privacy, such as the general data protection regulation (GDPR) of the European Union. Moreover, this allows reducing the amount of data being transmitted from the sensor device to the user device for the commissioning as no image data are transmitted.

The user device may be a conventional user device that is programmed by software, e.g. an app, in order to be configured to perform the steps for commissioning the sensor device in the area. In other words, the user device may be configured to be programmed by software, e.g. an app, in order to be configured to perform the commissioning. Thus, the user device is not necessarily a dedicated commissioning device used only for commissioning, but may be a conventional user device that may be programmed by software to perform the commissioning of the sensor device. The user device may be a portable device. The user device may be a user end device. The user device may be one of a smartphone, a tablet, a laptop etc. Optionally, the user device is a dedicated commissioning device. The user device is configured to generate the three-dimensional model of the area using the three-dimensional spatial data of the area without using image data of the area, such as image data of the area detected by the sensor device. The user device may be referred to as "commissioner device".

Herein, the term commissioning of a sensor device may be understood as the process of setting up the sensor device with regard to its desired installation location and installation orientation in an area. Commissioning allows setting configurations for the detection, such as time(s) during which detection by the sensor device is to be performed, to the sensor device, sensitivity level of the sensor device, detection field of the sensor device etc. Moreover, commissioning allows a user to set or configure the sensor device with regard to the desired installation location and orientation of the sensor, i.e. from the actual perspective of the sensor device once the sensor device is installed in the area as desired by the user.

The passage "desired installation location and orientation" means "desired installation location and desired installation orientation" and describes the desired location at which the sensor device is to be installed in the area and the desired orientation with which the sensor device is to be installed in the area, respectively. That is, they describe the actual location and actual orientation of the sensor device once the sensor device is installed in the area as desired, e.g. by the user. The term "planned" may be used as a synonym for the term "desired" and, thus, the terms "desired installation location", "desired installation orientation" and "desired spatial condition" may be referred to as "planned installation location", "planned installation orientation" and "planned spatial condition", respectively.

The sensor device may be the sensor device according to the third aspect of the present invention as described below. Thus, the description of the sensor device according to the third aspect may be correspondingly valid. The three-dimensional spatial data of the area may be spatial data detected by an active sensor unit. The three-dimensional spatial data may be native three-dimensional spatial data of a sensor. The three-dimensional spatial data may represent a point cloud. The three-dimensional model of the area may be a point cloud image of the area.

The user device may comprise a data processing unit for generating the three-dimensional models. The data processing unit may comprise at least one of controller(s), microcontroller(s), processor(s), microprocessor(s), application specific integrated circuit(s) (ASIC(s)), field programmable gate array(s) (FPGA(s)), etc.

The user device may comprise a display for displaying the three-dimensional model of the area to the user. The display may be a touch display and, thus, may function as input means for receiving information from the user. For example, the display being a touch display may be configured to display the generated three-dimensional model of the area and the user may directly input via the display the desired installation location and orientation of the sensor device in the area and the desired one or more spatial conditions in the area, e.g. by drawing, writing etc., on the display displaying the three-dimensional model of the area. The user device may comprise a user interface for displaying and receiving information, such as displaying the three-dimensional model and receiving the desired installation location and orientation of the sensor device and the desired one or more spatial conditions in the area. In other words, the user device may comprise a user interface via which information, e.g. the three-dimensional model of the area, may be output to the user and via which information, e.g. the aforementioned information with regard to the sensor device, may be input by the user to the user device. Such a user interface may be a touch display e.g. a display of a smartphone. The user interface may be differently implemented. For example, the user interface may comprise a display and separate input means, such as a computer mouse, touchpad, stylus pen, keyboard etc. The present invention is not limited to a specific user interface for outputting (e.g. displaying) information, such as the three-dimensional model of the area, and allowing inputting information, such as the aforementioned information with regard to the sensor device. Thus, any known user interface may be used. The present invention is not limited to a specific type of user device. Thus, any known user device may be used.

The user device is configured such that the user is able to input the desired installation location and orientation of the sensor device in the area and the one or more desired spatial conditions in the area to be considered by the sensor. The passage "the user device being configured to receive from the user information on the desired installation location and orientation of the sensor device in the area and on one or more desired spatial conditions in the area" means that the user device gets knowledge on the desired installation location and orientation of the sensor device in the area and on one or more desired spatial conditions. The aforementioned passage may be formulated as "the user device being configured to receive from the user the desired installation location and orientation of the sensor device in the area and one or more desired spatial conditions in the area". In addition, the user may input additional information for commissioning the sensor device. That is, the user device may be configured to receive further information for commissioning the sensor device from the user. The user device may be configured to provide the further information for commissioning the sensor device to the sensor device. The further information for commissioning may comprise e.g. time(s) during which detection by the sensor device is to be performed, sensitivity level of the sensor device, detection field of the sensor device etc.

The one or more spatial conditions in the area may be understood as spatial information that is to be considered by the sensor device as edge condition(s) when evaluating detection results, e.g. image data, of the sensor device. The terms "assumed spatial features" and "assumed spatial characteristics" may be used instead of the term "spatial conditions". The information on the one or more spatial conditions in the area may be information on assumed boundary/boundaries classifying or dividing the area in different section(s) with regard to which the taken image of the area is to be evaluated by the sensor device.

In order to be distinguishable from the second three-dimensional model, the three-dimensional model generated using the three-dimensional spatial data of the area may be referred to as "first three-dimensional model". The second three-dimensional model of the area may be the first three-dimensional model that indicates/ shows the desired installation location and desired installation orientation of the sensor device and the one or more spatial conditions in the area. In other words, displaying the second three-dimensional model corresponds to displaying first three-dimensional model of the area together with the desired installation location and desired installation orientation of the sensor device and the one or more spatial conditions in the area.

The user device may be configured to provide information, such as the second three-dimensional model of the area and optionally further information for commissioning the sensor device, to the sensor device by communicating with the sensor device. Such communication may be wired (e.g. via a data bus) and/or wireless. For example, the user device may be configured to communicate with sensor device via electromagnetic waves, such as radio waves (i.e. using radio signals). Optionally, the user device may be configured to wirelessly communicate with sensor device using pulse-based radio communication (PBRC) signals, such as ultra-wideband (UWB) signals. For example, the wireless communication may be according to at least one of Bluetooth communication, radio-frequency identification (RFID) communication (e.g. near field communication (NFR)), wireless local area network (WLAN) communication (e.g. WiFi communication) etc. For the communication with outside, e.g. the sensor device, the user device may comprise a communication unit (may be referred to as communication module). The present invention is not limited to a specific type of communication. Thus, the user device and sensor device may communicated with each other according to any known method.

The processing unit of the user device may be arranged in a housing of the user device. The user interface of the user device may be arranged in the housing of the user device, such that the user may interact, e.g. touch and see, at least a part of the user interface. The user interface may protrude at least partly out of the housing. The communication unit of the user device may be arranged in the housing of the user device. The communication unit may protrude at least partly out of the housing.

Herein, the area may be an indoor area, such as a room, hallway etc., or an outdoor area, such as a street, parking lot etc.

Optionally, the user device comprises a sensor unit configured to provide the three-dimensional spatial data of the area by performing a detection of the area. Optionally, the sensor unit is a light detection and ranging sensor unit (LiDAR sensor unit).

The sensor unit allows collecting locally at the user device the three-dimensional spatial data for generating the three-dimensional model and, thus, commissioning the sensor device. Therefore, the user device does not need using image data of the area received from outside, e.g. the sensor device, for commissioning the sensor device. This allows protecting the privacy of persons present in the area and no data need to be transmitted from the sensor device to the user device for the commissioning, which reduces the amount of data being communicated between the user device and the sensor device for the commissioning of the sensor device. The term "sensor module" may be used as a synonym for the term "sensor unit". The sensor unit may be an active sensor unit. The sensor unit may be configured to provide native three-dimensional spatial data. The sensor unit may be configured to provide the three-dimensional spatial data in the form of a point cloud. The three-dimensional model of the area may be a point cloud image of the area. Optionally, the sensor unit may be a stereo camera unit. The sensor unit may comprise or be one or more sensors. The sensor unit of the user device may be arranged in the housing of the user device. The sensor unit may protrude at least partly out of the housing.

Optionally, the user device is configured to receive from the user as the information on the one or more desired spatial conditions in the area one or more subareas of the area and/or one or more lines in the area with regard to which the sensor device is desired to evaluate the detection results.

The second three-dimensional model of the area may indicate the one or more subareas in the area and/or the one or more lines in the area. That is, the second three-dimensional model is the first three-dimensional model that indicates or shows in addition to the information of the first three-dimensional model the one or more subareas of the area and/or the one or more lines in the area. The user device, e.g. the display, may be configured to display the first three-dimensional model such that the user may indicate, e.g. draw, the one or more subareas and/or the one or more line(s) in the first three-dimensional model of the area. This allows inputting the one or more subareas of the area and/or the one or more lines as the information on the one or more spatial conditions in the area to the user device. Thus, the user device allows the user to indicate in the area subarea(s) with regard to which the sensor device should evaluate image data, i.e. an image, of the area taken by the sensor device and provide respective evaluation results to the user, e.g. via the user device. The user device allows the user to indicate in the area line(s) with regard to which the sensor device should evaluate the image data, i.e. the image, taken by the sensor device and provide respective evaluation results to the user, e.g. via the user device.

In order to achieve the user device according to the first aspect of the present invention, some or all of the above described optional features may be combined with each other.

According to a second aspect of the invention, a computer program for commissioning a sensor device in an area is provided. The computer program comprises instructions, which, when the program is executed by a user device, cause the user device to carry out the steps of generating a three-dimensional model of the area using three-dimensional spatial data of the area, displaying the generated three-dimensional model of the area to a user, receiving from the user information on a desired installation location and orientation of the sensor device in the area and on one or more desired spatial conditions in the area to be considered by the sensor device for evaluating detection results of the area by the sensor device, generating a second three-dimensional model of the area using the three-dimensional model of the area and the received information, the second three-dimensional model of the area comprising the information on the desired installation location and orientation of the sensor device in the area and the one or more desired spatial conditions in the area, and providing the generated second three-dimensional model of the area to the sensor device. The user device of the first aspect may be programmed with the computer program according to the second aspect.

The computer program may be an application, i.e. an app. The computer program may be installed on the user device according to the first aspect in order to configure the user device for its functionality of commissioning the sensor device. That is, the computer program may be installed at a conventional user device, such as a smartphone, a tablet, a laptop etc., in order for the conventional user device to be configured to commission the sensor device, as described herein. The computer program of the second aspect may be referred to as computer program for a user device instead of "computer program for commissioning a sensor device in an area".

The above description with regard to the user device according to the first aspect of the present invention is also valid for the computer program according to the second aspect of the present invention.

The computer program according to the second aspect achieves the same advantages as the user device according to the first aspect.

According to a third aspect of the invention, a sensor device is provided. The sensor device is configured to be installed at a desired installation location with a desired orientation in an area. The sensor device is configured to take an image of the area when being installed at the desired installation location with the desired orientation. The sensor device is configured to receive a three-dimensional model of the area comprising information on the desired installation location and orientation and on one or more desired spatial conditions in the area. The sensor device is configured to evaluate the taken image of the area according to the one or more desired spatial conditions in the area. The sensor device is configured to provide an evaluation result of the taken image to a user device.

By using the received three-dimensional model, e.g. from the user device (user device of the first aspect), the sensor device may be commissioned without the sensor device needing to provide image data of the area (i.e. the taken image of the area) to the user device. This allows protecting the privacy of persons present in the area and reduces an amount of data to be transmitted from the sensor device to the user device. Herein, taking an image of the area may comprise taking a real-time image of the area or a video stream of the area comprising multiple images. A description of evaluating an image is correspondingly valid for evaluating a video stream, i.e. evaluating multiple images forming the video stream.

The sensor device may be configured to provide an evaluation result of the taken image without the taken image to a user device.

The user device may be the user device of the first aspect. The description of the user device of the first aspect may be correspondingly valid for the sensor device. The sensor device may comprise one or more sensors for taking the image of the area. The one or more sensors may be one or more image sensors, such as charge-coupled device (CCD) sensor(s), active-pixel sensor(s) (e.g. CMOs sensor(s), etc. The one or more sensors may be one or more digital image sensors The one or more sensors may be one or more camera sensors. The one or more sensors are not limited to a specific type of sensors for taking the image. The sensor device may comprise a processing unit for evaluating the image data, i.e. the taken image. The data processing unit may comprise at least one of controller(s), microcontroller(s), processor(s), microprocessor(s), application specific integrated circuit(s) (ASIC(s)), field programmable gate array(s) (FPGA(s)), etc. The sensor device, especially the processing unit, may evaluate the taken image according to the one or more spatial conditions in the area according to any method known for evaluating image data. The one or more sensors and the processing unit may be arranged in a housing of the sensor device. The one or more sensors may protrude at least partly out of the housing. The sensor device may be referred to as "vision sensor device".

Herein, the desired installation location and the desired installation orientation is to be understood as the location and the orientation for which the commissioning of the sensor device is to be performed. Thus, once the commissioning is finished, the sensor device being installed at the desired installation location with the desired installation orientation is commissioned, i.e. set up, for detection of the area and, thus, ready to work according to the preferences of the user.

The description with regard to the communication by the user device is correspondingly valid for the sensor device. That is, the sensor device may be configured to communicate the evaluation results of the taken image to the user device. Thus, the user device may be configured to receive the evaluation results of the taken image from the sensor device. The user device may be configured to provide, e.g. display, the received evaluation results to the user.

Optionally, the sensor device is configured to determine whether the received three-dimensional model of the area matches the taken image of the area, and inform the user device on the determination result.

In other words, the sensor may be configured to determine whether spatial data except of the one or more desired spatial conditions in the area of the received three-dimensional model of the area match spatial data of the taken image of the area. The sensor device may be configured to compare the received three-dimensional model of the area, e.g. the spatial data except of the one or more desired spatial conditions in the area of the three-dimensional model, with the taken image of the area, e.g. the spatial data of the taken image. The received three-dimensional model of the area corresponds to the second three-dimensional model of the area described with regard to the user device of the first aspect. For checking whether the three-dimensional model of the area and the taken image match, any known method may be used.

Optionally, the sensor device is configured to start the evaluation of the taken image of the area according to the one or more desired spatial conditions in the area in response to determining that the received three-dimensional model of the area matches the taken image of the area.

That is, once the sensor device has determined that the received three-dimensional model of the area matches the taken image of the area, it knows that it is installed at the desired installation location with the desired orientation so that the desired spatial condition(s) are to be used by the sensor device for evaluating the image data, i.e. the taken image. Namely, the user has provided the one or more desired spatial condition(s) for being considered by the sensor device when evaluating the image taken by the sensor device under the assumption that the sensor device is installed at the desired installation location with the desired installation orientation.

Optionally, the information on the one or more desired spatial conditions in the area of the received three-dimensional model of the area comprises one or more subareas of the area, and the sensor device is configured to evaluate the taken image of the area with regard to the one or more subareas of the area.

Optionally, the sensor device is configured to evaluate the taken image by determining based on the taken image for each subarea of the one or more subareas a first number of persons in the subarea and/or a second number of person passing in a set distance by the subarea. The sensor device may be configured to provide as the evaluation result to the user device for each subarea of the one or more subarea the first number of persons and/or the second number of persons.

The sensor device may be configured to evaluate the image periodically. That is, the sensor device may periodically update for each subarea of the one or more subareas the first number of persons and/or the second number of person.

Optionally, the information on the one or more desired spatial conditions in the area of the received three-dimensional model of the area comprises one or more lines in the area, and the sensor device is configured to evaluate the taken image of the area with regard to the one or more lines in the area.

Optionally, the sensor device is configured to evaluate the taken image by determining based on the taken image for each line of the one or more lines in the area a third number of persons crossing the line from a first side of the line to a second side of the line and/or a fourth number of persons crossing the line from the second side of the line to the first side of the line. The sensor device may provide as the evaluation result to the user device for each line of the one or more lines the third number of persons and/or the fourth number of persons.

The sensor device may periodically update for each line of the one or more lines the third number of persons and/or the fourth number of person. The aforementioned numbering of the "first number of persons", "second number of persons", "third number of persons" and "fourth number of persons" is used for distinguishing the aforementioned different numbers of persons and not to indicate a specific order, categorization or the like.

In order to achieve the sensor device according to the third aspect of the present invention, some or all of the above described optional features may be combined with each other.

The sensor device according to the third aspect achieves the same advantages as the user device according to the first aspect.

The above description with regard to the user device according to the first aspect of the present invention is also valid for the sensor device according to the third aspect of the present invention. The above description with regard to the sensor device according to the third aspect of the present invention is also valid for the user device according to the first aspect of the present invention.

According to a fourth aspect of the invention, a computer program is provided. The computer program comprises instructions, which, when the program is executed by a sensor device configured to be installed at a desired installation location with a desired orientation in an area, cause the sensor device to carry out the steps of taking an image of the area when being installed at the desired location with the desired orientation, receiving a three-dimensional model of the area comprising information on the desired installation location and orientation and on one or more desired spatial conditions in the area, evaluating the taken image of the area according to the one or more desired spatial conditions in the area, and providing an evaluation result of the taken image to a user device.

The computer program of the fourth aspect may be an application, i.e. an app. The computer program may be installed on the sensor device according to the third aspect in order to configure the sensor device for its functionality of detecting/monitoring the area.

The above description with regard to the sensor device according to the third aspect of the present invention is also valid for the computer program according to the fourth aspect of the present invention.

The computer program according to the fourth aspect achieves the same advantages as the sensor device according to the third aspect.

According to a fifth aspect of the invention a system is provided. The system comprises a user device according to the first aspect of the present invention, as described above, and a sensor device according to the third aspect of the present invention, as described above. The user device is configured to commission the sensor device in an area.

The above description with regard to the user device according to the first aspect of the present invention and the sensor device according to the third aspect of the present invention is also valid for the system according to the fifth aspect of the present invention.

The system according to the fifth aspect achieves the same advantages as the user device according to the first aspect and the sensor device according to the third aspect.

According to a sixth aspect of the invention, a method for commissioning, by a user device, a sensor device in an area is provided. The method comprises generating, by the user device, a three-dimensional model of the area using three-dimensional spatial data of the area. The method comprises displaying, by the user device, the generated three-dimensional model of the area to a user. The method comprises receiving, by the user device, from the user information on a desired installation location and orientation of the sensor device in the area and on one or more desired spatial conditions in the area to be considered by the sensor device for evaluating detection results of the area by the sensor device. The method comprises generating, by the user device, a second three-dimensional model of the area using the three-dimensional model of the area and the received information, the second three-dimensional model of the area comprising the information on the desired installation location and orientation of the sensor device in the area and the one or more desired spatial conditions in the area. The method comprises providing, by the user device, the generated second three-dimensional model of the area to the sensor device. The method comprises installing the sensor device at the desired installation location with the desired orientation in the area. The method comprises taking, by the sensor device, an image of the area when being installed at the desired installation location with the desired orientation. The method comprises receiving, by the sensor device, from the user device the second three-dimensional model of the area. The method comprises evaluating, by the sensor device, the taken image of the area according to the one or more desired spatial conditions in the area of the second three-dimensional model of the area. The method comprises providing, by the sensor device, an evaluation result of the taken image to the user device.

Optionally, the method comprises providing, by a sensor unit of the user device, the three-dimensional spatial data of the area by performing a detection of the area.

The above description with regard to the user device according to the first aspect of the present invention and the sensor device according to the third aspect of the present invention is also valid for the method according to the sixth aspect of the present invention.

The method according to the sixth aspect achieves the same advantages as the user device according to the first aspect and the sensor device according to the third aspect.

According to a further aspect of the invention, a sensor device may be provided. The sensor device is configured to be installed at a desired installation location with a desired orientation in an area. The sensor device is configured to take an image of the area when being installed at the desired installation location with the desired orientation. The sensor device is configured to receive a three-dimensional model of the area comprising information on the desired installation location and orientation and on one or more desired spatial conditions in the area. The sensor device is configured to determine whether the received three-dimensional model of the area matches the taken image of the area, and inform the user device on the determination result.

Optionally, the sensor device is configured to evaluate the taken image of the area according to the one or more desired spatial conditions in the area. The sensor device is configured to provide an evaluation result of the taken image to a user device.

The above description with regard to the sensor device according to the third aspect of the present invention is also valid for the sensor device according to the further aspect of the present invention

The sensor device according to the further aspect of the present invention achieves the same advantages as the sensor device according to the third aspect.

All steps which are performed by the various entities described in the present application as well as the functionalities described to be performed by the various entities are intended to mean that the respective entity is adapted to or configured to perform the respective steps and functionalities.

In the following, the invention is described exemplarily with reference to the enclosed figures (FIGs.), in which
- **FIG. 1**: shows an example of a user device according to the present invention,,
- **FIG. 2**: shows an example of a sensor device according to the present invention,
- **FIG. 3**: shows an example of a system according to the present invention, and
- **FIGs. 4A, 4B and 4C**: show an example of a method according to the present invention,

In the figures (FIGs.) corresponding elements have the same reference signs.

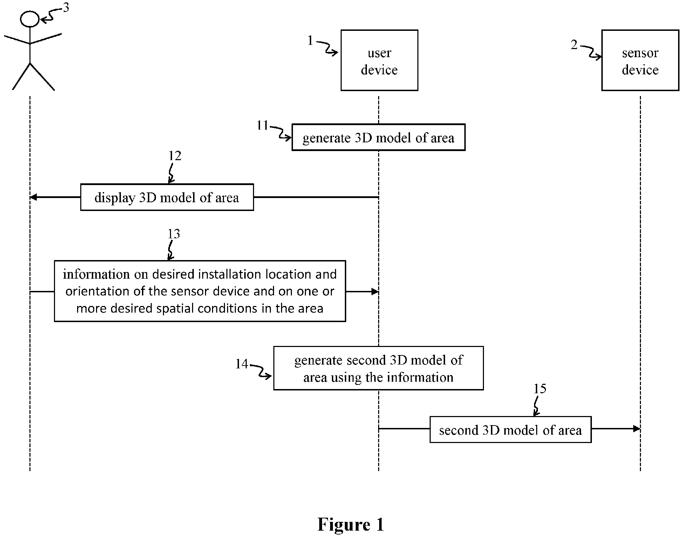

**FIG. 1** shows an example of a user device according to the present invention. The user device of FIG. 1 is an example of the user device according to the first aspect of the invention. Thus, the description of the user device of the first aspect of the invention is correspondingly valid for the user device of FIG. 1.

The user device 1 of FIG. 1 is for commissioning a sensor device 2 in an area. That is, the user device 1 is configured to commission the sensor device 2. The user device 1 is configured to generate a three-dimensional model of the area using three-dimensional spatial data of the area. The user device 1 is configured to display the generated three-dimensional model of the area to a user 3 (which uses the user device 1). The user device 1 is configured to receive from the user 3 information on a desired installation location and orientation of the sensor device 2 in the area and on one or more desired spatial conditions in the area to be considered by the sensor device 2 for evaluating detection results of the area by the sensor device 2. The user device 1 is configured to generate a second three-dimensional model of the area using the three-dimensional model of the area and the received information, the second three-dimensional model of the area comprising the information on the desired installation location and orientation of the sensor device 2 in the area and the one or more desired spatial conditions in the area. The user device 1 is configured to provide the generated second three-dimensional model of the area to the sensor device 2.

That is, the user device 1 is configured to perform the step 11 of generating the three-dimensional model, the step 12 of displaying the three-dimensional model (generated in step 11), the step 13 of receiving from the user 3 the information on a desired installation location and orientation of the sensor device 2 in the area and on one or more desired spatial conditions in the area, the step 14 of generating the second three-dimensional model using the three-dimensional model of the area (generated in step 11) and the information from the user 3 (received in step 13), and the step 15 of providing (for example transmitting, such as wirelessly transmitting) the second three-dimensional model to the sensor device 2. The method steps 11, 12, 13, 14 and 15 may be part of a method that may be performed by the user device 1 for commissioning the sensor device 2. For example, the user device 1 may be configured for such a commissioning of the sensor device 2 by installing a computer program, e.g. app, on the user device. The computer program comprises instructions, which, when the program is executed by the user device 1 cause the user device to carry out the steps 11, 12, 13, 14 and 15, described above and shown in FIG. 1. Such computer program is an example of the computer program according to the second aspect of the invention.

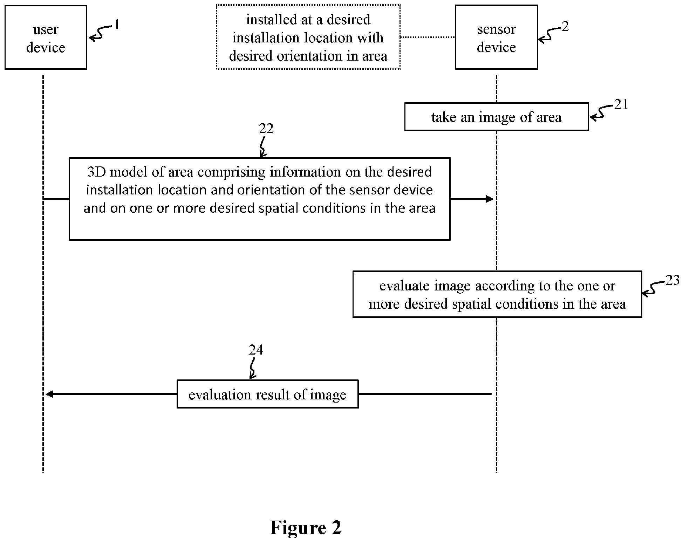

The sensor device shown in FIG. 1 may be the sensor device 2 of FIG. 2.

For further details, e.g. optional features and/or implementation forms, on the user device 1 reference is made to the description of the user device of the first aspect, the computer program of the second aspect, the system of the fifth aspect and the method of the sixth aspect of the invention as well as to the following description with regard to FIGs. 2, 3, 4A, 4B and 4C.

**FIG. 2** shows an example of a sensor device according to the present invention. The sensor device of FIG. 2 is an example of the sensor device according to the third aspect of the invention. Thus, the description of the sensor device of the third aspect of the invention is correspondingly valid for the sensor device of FIG. 2.

As shown in FIG. 2, the sensor device 2 is configured to be installed at a desired installation location with a desired orientation in an area. A user 3 may install the sensor device 2 at the desired installation location with the desired installation orientation in the area. The sensor device 2 is configured to take an image of the area when being installed at the desired installation location with the desired orientation. The sensor device 2 is configured to receive a three-dimensional model of the area comprising information on the desired installation location and orientation and on one or more desired spatial conditions in the area. The sensor device 2 may receive the three-dimensional model of the area from a user device 1 for commissioning the sensor device 2. The user device 1 shown in FIG. 1 may be the user device 1 of FIG. 2. Thus, the three-dimensional model received by the sensor unit 2 of FIG. 2 corresponds to the second three-dimensional model provided by the user device 1 of Figure 1 (in step 15) to the sensor device 2. The sensor device 2 is configured to evaluate the taken image of the area according to the one or more desired spatial conditions in the area. The sensor device 2 is configured to provide an evaluation result of the taken image to the user device 1.

That is, the sensor device 2 is configured to perform the step 21 of taken the image of the area (in which it is installed at the desired installation location with the desired orientation), the step 22 of receiving (e.g. wirelessly receiving) the three-dimensional model (from the user device 1), the step 23 of evaluating the image (taken in step 21) according to the one or more desired spatial condition in the area (received in step 22 as part of the three-dimensional model of the area) and the step 24 of providing (for example transmitting, such as wirelessly transmitting) the evaluation results (of step 23) to the user device 1. The sensor device 2 may perform the steps 21 and 22 in any order and, thus, is not limited to the order shown in Figure 2. The step 22 of FIG. 2 corresponds to the step 15 of FIG. 1. Thus, the user device 1 and the sensor device 2 may communicate (e.g. wirelessly communicate) with each other in order for the (second) three-dimensional model comprising the information on the desired installation location and orientation and on one or more desired spatial conditions in the area to be provided by the user device 1 to the sensor device 2. Accordingly. the user device 1 and the sensor device 2 may communicate (e.g. wirelessly communicate) with each other in order for the evaluation results (of evaluating the image according to the one or more desired spatial conditions in the area in step 23) to be provided by the sensor device 2 to the user device 1.

The method steps 21, 22, 23, and 24 of FIG. 2 may be part of a method that may be performed by the sensor device 2. For example, the sensor device 2 may be configured for sensing/ detecting the area by installing a computer program, e.g. app, on the sensor device 2. The computer program comprises instructions, which, when the program is executed by the sensor device 2 cause the sensor device 2 to carry out the steps 21, 22, 23, and 24, described above and shown in FIG. 2. Such computer program is an example of the computer program according to the fourth aspect of the invention.

For further details, e.g. optional features and/or implementation forms, on the sensor device 2 reference is made to the description of the sensor device of the third aspect, the computer program of the fourth aspect, the system of the fifth aspect and the method of the sixth aspect of the invention as well as to the description with regard to FIGs. 1, 3, 4A, 4B and 4C.

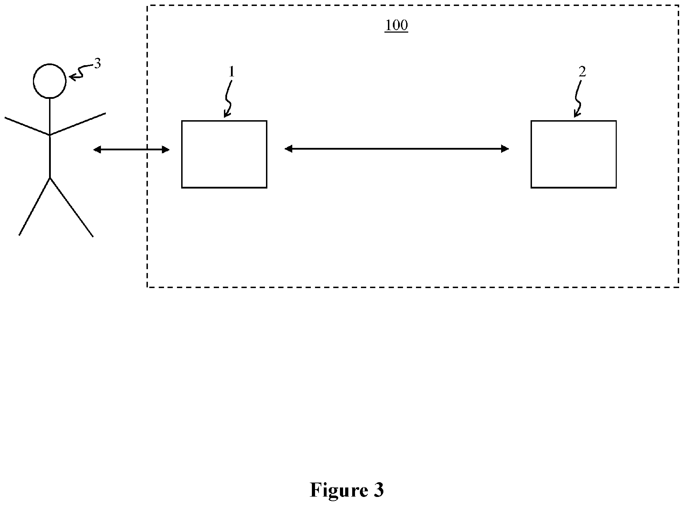

**FIG. 3** shows an example of a system according to the present invention. The system of FIG. 3 is an example of the system according to the fifth aspect of the invention.

Thus, the description of the system of the fifth aspect of the invention is correspondingly valid for the system of FIG. 3.

As shown in FIG. 3, the system 100 comprises the user device 1 of FIG. 1, and the sensor device 2 of FIG. 2. The user device 1 is configured to commission the sensor device 2 in an area, in which the sensor device 2 is to be installed at a desired installation location with a desired orientation, as desired by a user 3. The user 3 may install the sensor device 2 in the area at the desired installation location with the desired orientation. As indicated by the double arrow between the user 3 and the user device 1 in FIG. 3, the user 3 may use, optionally operate, the user device 1 for commissioning the sensor device 2 via the user device 1. For this, the user device 1 may output, e.g. display, information to the user 3 and the user 3 may input information, such as the desired installation location and orientation and one or more desired spatial conditions in the area to be considered by the sensor device 2 for evaluating detection results of the area by the sensor device 2, to the user device 1. For outputting, e.g. displaying, by the user device 1 information, such as three-dimensional model(s) of the area, to the user 3 and inputting information by the user 3 to the user device 1, the present invention is not limited to a specific type of user device and specific means of such device for achieving the aforementioned. Optionally, the user 3 may start a software, such as an application (i.e. app), on the user device 1 (e.g. being a smartphone, tablet, laptop etc.) for commissioning the sensor device 2 via the user device 1. The software (e.g. app) may provide different views on a display for allowing an output of information (such as the three-dimensional model of the area) by the user device 1 and an input of data (such as the information outlined in step 13 of FIG. 1) by the user 3 to the user device 1.

As shown in FIG. 3 by the double arrow between the user device 1 and the sensor device 2, the user device 1 and the sensor device 2 are configured to communicate with each other. The communication may be wired and/or wireless. The present invention is not limited to a specific way of communication between the user device 1 and the sensor device 2. Thus, they may communicate with each other according to any method known.

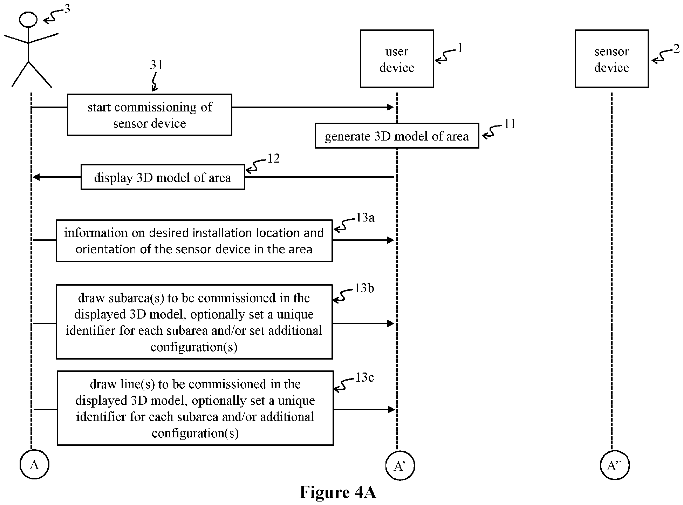

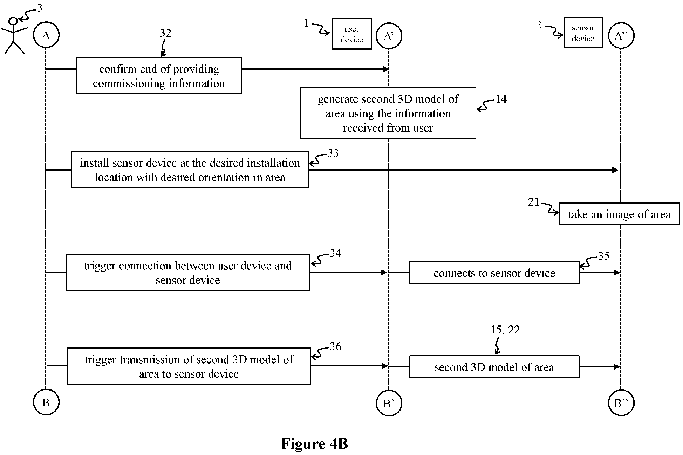

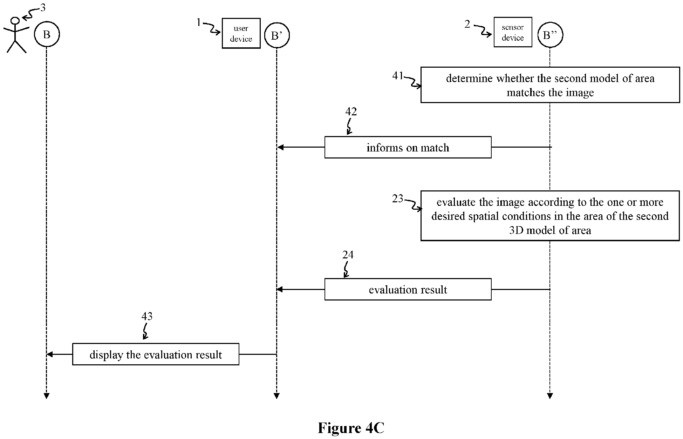

**FIGs. 4A****,** **4B** **and** **4C** show an example of a method according to the present invention. The method of FIGs. 4A, 4B and 4C is an example of the method according to the sixth aspect of the invention. Thus, the description of the method of the sixth aspect of the invention is correspondingly valid for the method of FIGs. 4A, 4B and 4C. The user device 1 is the user device 1 of FIGs. 1 and 3 and the sensor device 2 is the sensor device 2 of FIGs. 2 and 3. In the following description it is assumed that the user device 1 is a smartphone, on which an app is installed for performing the commissioning of the sensor device 2 by the user 3 via the user device 1. This is only by way of example and, thus, the following description is correspondingly valid in case the user device 1 is not a smartphone, but a different type of user device. The sensor device 2 is assumed to be a sensor device for monitoring the area in which it is installed by taking images of the area. Moreover, the sensor device 2 is assumed to evaluate the taken images by counting persons present in the area. The present invention is not limited to a specific way of evaluating the images and, thus, any known methods for processing image data and, thus, evaluating the taken images may be used. The present invention is not limited to such assumed sensor device and, thus, the following description is correspondingly valid in case of using a different type of sensor device 2, e.g. a sensor device 2 taking images of the area but evaluating the images for different reason(s). The area, in which the sensor device 2 is installed, may be an indoor area, such as a room, hallway etc., or an outdoor area, such as a street, parking lot etc.

Since the user 3 commissions the sensor device 2 using the user device 1, the user 3 may be called "commissioner". The user 3 may start the commissioning of the sensor device 2 in an area by using the smartphone 1 i.e. the user device 1 (cf. step 31 of FIG. 4A). For example, the user 3 may start the commissioning by opening an app, e.g. commissioning app. In response thereto, the smartphone 1 may generate a three-dimensional model of the area using three-dimensional spatial data of the area (cf. step 11 of FIG. 4A). Optionally, the smartphone may comprise a sensor unit, such as a LiDAR sensor unit, that is configured to provide the three-dimensional spatial data of the area by performing a detection of the area. In other words, a sensor unit of the smartphone 1 may scan the area, thereby collecting three-dimensional spatial data of the area for generating the three-dimensional model. Next, the smartphone 1 may display the generated three-dimensional model of the area in the app to the user 3 (cf. step 12 of FIG. 4A). That is, the smartphone 1 may return a three-dimensional view in the form of a three-dimensional model of the area in the app.

The smartphone 1 may receive from the user 3 information on a desired installation location and orientation of the sensor device 2 in the area and on one or more desired spatial conditions in the area to be considered by the sensor device 2 for evaluating detection results of the area by the sensor device 2. For this, the user 3 may input different information/data via the app to the smartphone 1. The user 3 may input to the smartphone information on the desired installation location and desired installation orientation of the sensor device 2 in the area (cf. step 13a of FIG. 4A). For example, the user may do this by indicating, e.g. drawing, the desired location and desired orientation of the sensor device 2 in the three-dimensional model of the area displayed by the app of the smartphone 1. That is, the user 3 may locate using the three-dimensional model of the area the sensor device 2 in the area including the orientation of the sensor device 2 in the area. For example, the orientation of the sensor device 2 may be indicted by setting the north pole direction, i.e. the direction towards the north pole, of the sensor device 2 in the area. The user 3 may input to the smartphone as information on the one or more desired spatial conditions in the area information on one or more subareas of the area (cf. step 13b of FIG. 4A). For example, the user 3 may indicate, e.g. draw, the one or more subarea(s) of the area in the three-dimensional model of the area displayed by the app of the smartphone 1. The one or more subareas are subareas of the area to be commissioned in the displayed three-dimensional model of the area. Optionally, the user 3 may set a unique identifier (e.g. unique name) for each subarea. Optionally, the user 3 may input additional information to the smartphone 1 to set further configurations for the detection by the sensor device 2, such as time(s) during which detection by the sensor device 2 is to be performed, sensitivity level of the sensor device, detection field of the sensor device etc. In addition or alternatively, the user 3 may input to the smartphone 1 as information on the one or more desired spatial conditions in the area information on one or more lines in the area (cf. step 13c of FIG. 4A). For example, the user 3 may indicate, e.g. draw, the one or more lines in the area in the three-dimensional model of the area displayed by the app of the smartphone 1. The one or more lines are line (s) of the area to be commissioned in the displayed three-dimensional model of the area. Optionally, the user 3 may set a unique identifier (e.g. unique name) for each line.

The steps 13a, 13b and 13c may be performed in any order by the user. One of the steps 13b and 13c or both steps 13b and 13c may be performed by the user 3. The description continues with regard to FIG. 4B.

The user 3 may confirm an end of providing commissioning information (cf. step 32 of FIG. 4B), such as the information outlined above with respect to steps 13a, 13b and 13c of FIG. 4A. The user 3 may do this via the app of the smartphone 1. In response thereto, the smartphone 1 may generate a second three-dimensional model of the area using the three-dimensional model of the area and the information for commissioning received from the user 3 (step 14 of FIG. 4B). The second three-dimensional model of the area comprises the information on the desired installation location and orientation of the sensor device 2 in the area and the one or more desired spatial conditions in the area (e.g. the one or more subarea(s) of the area and/or the one or more line(s) in the area). Next, the user 3 may install the sensor device 2 in the area at the desired installation location with the desired orientation (cf. step 33 of FIG. 4B), which the user 3 has input in the app as commissioning information in step 13a. That is, the user 3 may mount the sensor device 1 at the preferred location in the area with the same north pole direction as defined in the commissioning via the app of the smartphone 1. The sensor device 2 may take an image of the area when being installed at the desired installation location with the desired orientation in the area (cf. step 21 of FIG. 4B).

The user 3 may trigger a connection between the smartphone 1 and the sensor device 2 for a communication between them (cf. step 34 of FIG. 4B). The connection may be wireless and, thus, the user 3 may trigger a wireless communication between the smartphone 1 and the sensor device 2. For this the user 3 may search for the sensor device 2 in a list of devices configured for wireless communication displayed in the app of the smartphone 1. The wireless communication may be for example a Bluetooth communication, a WLAN communication etc. After having selected the sensor device 2 for the communication, the smartphone may establish a communication connection with the sensor device 2, i.e. it connects to the sensor device 2 (cf. step 35 of FIG. 4B). The present invention is not limited to a specific type of communication between the smartphone 1, i.e. the user device, and the sensor device 2. Thus, any known type of communication, such as a wired communication (e.g. via a data bus), may be implemented and the description herein is correspondingly valid.

The user 3 may trigger transmission of the second three-dimensional model of the area to the sensor device 2 (cf. step 36 of FIG. 4B). For this, the user 3 may select the second three-dimensional model of the area to be transmitted/send by the smartphone 1 to the sensor device 2. For example, the user 3 may select the correct commissioned three-dimensional model of the area, namely the second three-dimensional model of the area, in the app, for example in an app planning repository. Thus, the smartphone 1 transmits the second three-dimensional model of the area and optionally furhter configuration(s), such as time(s) during which detection by the sensor device is to be performed, to the sensor device, sensitivity level of the sensor device, detection field of the sensor device etc., to the sensor device 1 (cf. step 15 of FIG. 4B), wherein the sensor device receives this information (cf. step 22 of FIG. 4B). The step 21 of FIG. 4B may be performed after the step 35 or step 22 of FIG. 4B. The description continues with regard to FIG. 4C.

The sensor device 2 may determine whether the received second model of the area matches the taken image of the area (cf. step 41 of FIG. 4C). The sensor device 2 may internally compare the image taken by itself with the received second three-dimensional model of the area and may apply the one or more desired spatial conditions in the area of the second three-dimensional model. The one or more desired spatial conditions in the area may be referred to as "commissioning requirements". In case the taken image matches the received second three-dimensional model of the area, the sensor device 2 may inform the smartphone 1 on this match (cf. step 42 of FIG. 4C). The smartphone 1 may display this information in the app.

The sensor device 2 may evaluate the image of the area, i.e. its detection results, according to the one or more desired spatial conditions in the area of the second three-dimensional model of the area (cf. step 23 of FIG. 4C). That is, the sensor device 2 may evaluate the image of the area with regard to the one or more subareas of the area and/or one or more lines comprised by the second three-dimensional model of the area as one or more desired spatial condition in the area to be considered by the sensor device 2 for evaluating its detection results. In other words, the sensor device 2 may process the commissioned three-dimensional model of the area received from the smartphone 1 with the information for the installation location and orientation (e.g. north pole direction) of the sensor device as well as subarea(s) of the area and/or line(s) in the area. For example, the sensor device 2 may evaluate the taken image by determining based on the taken image for each subarea of the one or more subareas a first number of persons in the subarea and/or a second number of person passing in a set distance by the subarea. For example, the sensor device 2 may evaluate the taken image by determining based on the taken image for each line of the one or more lines in the area a third number of persons crossing the line from a first side of the line to a second side of the line and/or a fourth number of persons crossing the line from the second side of the line to the first side of the line. For example, in case a line is draw at a door of the room, this allows determining a number of persons entering the room and a number of person leaving the room.

The sensor device 2 may transmit the evaluation results to the smartphone 1 (cf. step 24 of FIG. 4C). For example, the sensor device 2 may provide as the evaluation result to the smartphone at least one of: for each subarea of the one or more subarea the first number of persons, for each subarea of the one or more subarea the first number of persons the second number of persons, for each line of the one or more lines the third number of persons and for each line of the one or more lines the fourth number of persons. The smartphone 1 may display in the app the received evaluation results (cf. step 43 of FIG. 4C). That is, after the sensor device 2 confirms that the received second three-dimensional model of the area matches the image taken by the sensor device 2 of the area, the sensor device 1 may start collecting the data of the area based on the image as specified by the second three-dimensional model, especially the one or more desired spatial conditions in the area. The smartphone 1 may display the evaluation results on the app, matching the second three-dimensional model of the area. The smartphone 1 may display the evaluation results together with the second three-dimensional model of the area in the app. This allows checking for potential commissioning mistakes. For example, if the number of persons in an subarea differs from the actual number of persons counted by the user in the area, this may indicate a commissioning mistake.

The present invention has the advantage that the user 3 never sees the real-life stream or image of the area from the sensor device 1. Namely, the smartphone displays to the user 3 three-dimensional models of the area, which do not contain personally identifiable data. Thus, the present invention allows protecting the privacy of persons present in the area and allows reducing the amount of data being transmitted from the sensor device 2 to the smartphone 1. Namely, no image data are transmitted from the sensor device 2 to the smartphone 1 for the commissioning of the sensor device 2. The evaluation results of the image allow an occupancy analysis of the area.

In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A user device (1) for commissioning a sensor device (2) in an area, wherein the user device (1) is configured to
- generate (11) a three-dimensional model of the area using three-dimensional spatial data of the area,
- display (12) the generated three-dimensional model of the area to a user (3),
- receive (13) from the user (3) information on a desired installation location and orientation of the sensor device in the area and on one or more desired spatial conditions in the area to be considered by the sensor device for evaluating detection results of the area by the sensor device (1),
- generate (14) a second three-dimensional model of the area using the three-dimensional model of the area and the received information, the second three-dimensional model of the area comprising the information on the desired installation location and orientation of the sensor device in the area and the one or more desired spatial conditions in the area, and
- provide (15) the generated second three-dimensional model of the area to the sensor device (2).

2. The user device (1) according to claim 1, wherein
- the user device (1) comprises a sensor unit, such as a light detection and ranging, LiDAR, sensor unit, configured to provide the three-dimensional spatial data of the area by performing a detection of the area.

3. The user device (1) according to claim 1 or 2, wherein
- the user device (1) is configured to receive (13) from the user (3) as the information on the one or more desired spatial conditions in the area one or more subareas of the area and/or one or more lines in the area with regard to which the sensor device (1) is desired to evaluate the detection results.

4. A computer program for commissioning a sensor device (2) in an area, comprising instructions, which, when the program is executed by a user device (1), cause the user device (1) to carry out the steps of
- generating (11) a three-dimensional model of the area using three-dimensional spatial data of the area,
- displaying (12) the generated three-dimensional model of the area to a user,
- receiving (13) from the user information on a desired installation location and orientation of the sensor device in the area and on one or more desired spatial conditions in the area to be considered by the sensor device for evaluating detection results of the area by the sensor device,
- generating (14) a second three-dimensional model of the area using the three-dimensional model of the area and the received information, the second three-dimensional model of the area comprising the information on the desired installation location and orientation of the sensor device in the area and the one or more desired spatial conditions in the area, and
- providing (15) the generated second three-dimensional model of the area to the sensor device.

5. A sensor device (2) configured to
- be installed at a desired installation location with a desired orientation in an area,
- take(21) an image of the area when being installed at the desired installation location with the desired orientation,
- receive (22) a three-dimensional model of the area comprising information on the desired installation location and orientation and on one or more desired spatial conditions in the area,
- evaluate (23) the taken image of the area according to the one or more desired spatial conditions in the area, and
- provide (24) an evaluation result of the taken image to a user device (1).

6. The sensor device (2) according to claim 5, wherein
- the sensor device (2) is configured to determine (41) whether the received three-dimensional model of the area matches the taken image of the area, and inform (42) the user device (1) on the determination result.

7. The sensor device (2) according to claim 6, wherein
- the sensor device is configured to start the evaluation (23) of the taken image of the area according to the one or more desired spatial conditions in the area in response to determining that the received three-dimensional model of the area matches the taken image of the area.

8. The sensor device (2) according to any one of claims 5 to 7, wherein
- the information on the one or more desired spatial conditions in the area of the received three-dimensional model of the area comprises one or more subareas of the area, and
- the sensor device (2) is configured to evaluate the taken image of the area with regard to the one or more subareas of the area.

9. The sensor device (2) according to claim 8, wherein
- the sensor device (2) is configured to evaluate the taken image by determining based on the taken image for each subarea of the one or more subareas a first number of persons in the subarea and/or a second number of person passing in a set distance by the subarea, and
- provide (2) as the evaluation result to the user device (1) for each subarea of the one or more subarea the first number of persons and/or the second number of persons.

10. The sensor device (2) according to any one of claims 5 to 9, wherein
- the information on the one or more desired spatial conditions in the area of the received three-dimensional model of the area comprises one or more lines in the area, and
- the sensor device (2) is configured to evaluate the taken image of the area with regard to the one or more lines in the area.

11. The sensor device (2) according to claim 10, wherein the sensor device (2) is configured to
- evaluate the taken image by determining based on the taken image for each line of the one or more lines in the area a third number of persons crossing the line from a first side of the line to a second side of the line and/or a fourth number of persons crossing the line from the second side of the line to the first side of the line, and
- provide as the evaluation result to the user device for each line of the one or more lines the third number of persons and/or the fourth number of persons.

12. A computer program, comprising instructions, which, when the program is executed by a sensor device (2) configured to be installed at a desired installation location with a desired orientation in an area, cause the sensor device (2) to carry out the steps of
- taking (21) an image of the area when being installed at the desired location with the desired orientation,
- receiving (22) a three-dimensional model of the area comprising information on the desired installation location and orientation and on one or more desired spatial conditions in the area,
- evaluating (23) the taken image of the area according to the one or more desired spatial conditions in the area, and
- providing (24) an evaluation result of the taken image to a user device.

13. A system (100) comprising
- a user device (1) according to any one of claims 1 to 3, and
- a sensor device (2) according to any one of claims 5 to 11, wherein
- the user device (1) is configured to commission the sensor device (2) in an area.

14. A method for commissioning, by a user device (1), a sensor device (2) in an area, the method comprising:
- generating (11), by the user device (1), a three-dimensional model of the area using three-dimensional spatial data of the area,
- displaying (12), by the user device (1), the generated three-dimensional model of the area to a user (3),
- receiving (13), by the user device (1), from the user (3) information on a desired installation location and orientation of the sensor device in the area and on one or more desired spatial conditions in the area to be considered by the sensor device (1) for evaluating detection results of the area by the sensor device,
- generating (14), by the user device (1), a second three-dimensional model of the area using the three-dimensional model of the area and the received information, the second three-dimensional model of the area comprising the information on the desired installation location and orientation of the sensor device (2) in the area and the one or more desired spatial conditions in the area,
- providing (15), by the user device, the generated second three-dimensional model of the area to the sensor device,
- installing (33) the sensor device (2) at the desired installation location with the desired orientation in the area,
- taking (21), by the sensor device (2), an image of the area when being installed at the desired installation location with the desired orientation,
- receiving (22), by the sensor device (2), from the user device the second three-dimensional model of the area,
- evaluating (23), by the sensor device (2), the taken image of the area according to the one or more desired spatial conditions in the area of the second three-dimensional model of the area, and
- providing (24), by the sensor device (2), an evaluation result of the taken image to the user device.

15. The method according to claim 14, wherein the method comprises
- providing, by a sensor unit of the user device (1), the three-dimensional spatial data of the area by performing a detection of the area.

## Amended claims

### Amended claims in accordance with Rule 137(2) EPC.

1. A system (100) comprising
- a user device (1) and a sensor device (2)
- the user device (1) is for commissioning the sensor device (2) in an area, wherein the user device (1) is configured to
- generate (11) a three-dimensional model of the area using three-dimensional spatial data of the area,
- display (12) the generated three-dimensional model of the area to a user (3),
- receive (13) from the user (3) information on a desired installation location and orientation of the sensor device in the area and on one or more desired spatial conditions in the area to be considered by the sensor device for evaluating detection results of the area by the sensor device (1),
- generate (14) a second three-dimensional model of the area using the three-dimensional model of the area and the received information, the second three-dimensional model of the area comprising the information on the desired installation location and orientation of the sensor device in the area and the one or more desired spatial conditions in the area, and
- provide (15) the generated second three-dimensional model of the area to the sensor device (2), wherein
- the user device (1) is configured to receive (13) from the user (3) as the information on the one or more desired spatial conditions in the area one or more subareas of the area and/or one or more lines in the area with regard to which the sensor device (1) is desired to evaluate the detection results; and
- the sensor device (2) configured to
- be installed at the desired installation location with the desired orientation in the area,
- take (21) an image of the area when being installed at the desired installation location with the desired orientation,
- receive (22) the second three-dimensional model of the area, as provided by the user device, comprising information on the desired installation location and orientation and on one or more desired spatial conditions in the area,
- evaluate (23) the taken image of the area according to the one or more desired spatial conditions in the area, and
- provide (24) an evaluation result of the taken image to the user device (1), wherein
- the information on the one or more desired spatial conditions in the area of the received three-dimensional model of the area comprises one or more subareas of the area and/or one or more lines in the area, and
- the sensor device (2) is configured to evaluate the taken image of the area with regard to the one or more subareas of the area and/or the one or more lines in the area; wherein
- the user device (1) is configured to commission the sensor device (2) in the area.

2. The user device (1) according to claim 1, wherein
- the user device (1) comprises a sensor unit, such as a light detection and ranging, LiDAR, sensor unit, configured to provide the three-dimensional spatial data of the area by performing a detection of the area.

3. The sensor device (2) according to any of the preceding claims , wherein
- the sensor device (2) is configured to determine (41) whether the received three-dimensional model of the area matches the taken image of the area, and inform (42) the user device (1) on the determination result.

4. The sensor device (2) according to claim 3, wherein
- the sensor device is configured to start the evaluation (23) of the taken image of the area according to the one or more desired spatial conditions in the area in response to determining that the received three-dimensional model of the area matches the taken image of the area.

5. The sensor device (2) according to any of the preceding claims, wherein
- the sensor device (2) is configured to evaluate the taken image by determining based on the taken image for each subarea of the one or more subareas a first number of persons in the subarea and/or a second number of person passing in a set distance by the subarea, and
- provide (2) as the evaluation result to the user device (1) for each subarea of the one or more subarea the first number of persons and/or the second number of persons.

6. The sensor device (2) according to any of the preceding claims, wherein the sensor device (2) is configured to
- evaluate the taken image by determining based on the taken image for each line of the one or more lines in the area a third number of persons crossing the line from a first side of the line to a second side of the line and/or a fourth number of persons crossing the line from the second side of the line to the first side of the line, and
- provide as the evaluation result to the user device for each line of the one or more lines the third number of persons and/or the fourth number of persons.

7. A method for commissioning, by a user device (1), a sensor device (2) in an area, the method comprising:
- generating (11), by the user device (1), a three-dimensional model of the area using three-dimensional spatial data of the area,
- displaying (12), by the user device (1), the generated three-dimensional model of the area to a user (3),
- receiving (13), by the user device (1), from the user (3) information on a desired installation location and orientation of the sensor device in the area and on one or more desired spatial conditions in the area to be considered by the sensor device (1) for evaluating detection results of the area by the sensor device, wherein
- receiving (13) from the user (3) as the information on the one or more desired spatial conditions in the area one or more subareas of the area and/or one or more lines in the area with regard to which the sensor device (1) is desired to evaluate the detection results,
- generating (14), by the user device (1), a second three-dimensional model of the area using the three-dimensional model of the area and the received information, the second three-dimensional model of the area comprising the information on the desired installation location and orientation of the sensor device (2) in the area and the one or more desired spatial conditions in the area,
- providing (15), by the user device, the generated second three-dimensional model of the area to the sensor device,
- installing (33) the sensor device (2) at the desired installation location with the desired orientation in the area,
- taking (21), by the sensor device (2), an image of the area when being installed at the desired installation location with the desired orientation,
- receiving (22), by the sensor device (2), from the user device the second three-dimensional model of the area,
- evaluating (23), by the sensor device (2), the taken image of the area according to the one or more desired spatial conditions in the area of the second three-dimensional model of the area, wherein
- the information on the one or more desired spatial conditions in the area of the received three-dimensional model of the area comprises one or more subareas of the area and/or one or more lines in the area, and
- the step of evaluating (23) the taken image of the area is performed with regard to the one or more subareas of the area and/or the one or more lines in the area, and
- providing (24), by the sensor device (2), an evaluation result of the taken image to the user device.

8. The method according to claim 7, wherein the method comprises
- providing, by a sensor unit of the user device (1), the three-dimensional spatial data of the area by performing a detection of the area.
